# EUROPÄISCHE PATENTSCHRIFT

(11) **EP 1 304 748 B1**
(45) Veröffentlichungstag und Bekanntmachung des Hinweises auf die Patenterteilung: **21.04.2010**
(21) Anmeldenummer: 02022993.6
(22) Anmeldetag: 15.10.2002
(51) Int. Cl.: H01L 31/18, H01L 31/0216

(54) **Verfahren zur Herstellung einer Solarzelle**
Method for producing a solar cell
Méthode de fabrication d'une cellule solaire

(30) Priorität: 19.10.2001 DE 10152707
(43) Veröffentlichungstag der Anmeldung: 23.04.2003
(73) Patentinhaber: SCHOTT Solar AG, 55122 Mainz (DE)
(72) Erfinder: Lauinger, Thomas, Dr., 63843 Niedernberg (DE); Schwirtlich, Ingo, Dr., 63987 Miltenberg (DE); Moschner, Jens, 27404 Zeven (DE)
(74) Vertreter: Stoffregen, Hans-Herbert

(56) Entgegenhaltungen:
- US-A- 4 253 881
- US-A- 4 869 755
- "Low-temperature nitridation of silicon surface using NH3-decomposed species in a catalytic chemical vapor deposition system" 8. September 1997 (1997-09-08), APPLIED PHYSICS LETTERS, AIP, AMERICAN INSTITUTE OF PHYSICS, MELVILLE, NY, US, PAGE(S) 1371 , XP012018546 ISSN: 0003-6951 * das ganze Dokument *
- LEGUIJT C ET AL: "Low temperature surface passivation for silicon solar cells" 1. August 1996 (1996-08-01), SOLAR ENERGY MATERIALS AND SOLAR CELLS, ELSEVIER SCIENCE PUBLISHERS, AMSTERDAM, NL, PAGE(S) 297-345 , XP004008111 ISSN: 0927-0248 * Zusammenfassung * * Absatz 4.1.1 "Role of hydrogen from anneal ambient; Introduction" *

## Beschreibung

Die Erfindung bezieht sich auf ein Verfahren zur Herstellung einer Solarzelle unter Ausbildung einer wasserstoffhaltigen Silicium enthaltenden Schicht in Form einer Passivierungs- und/oder Antireflexionsschicht auf einem aus Silicium bestehenden oder dieses enthaltenden Substrat wie Scheibe oder Folie.

Über 80 % aller Solarzellen werden derzeit aus kristallinen Siliciumscheiben gefertigt, welche entweder nach der Czochralski-Methode oder mittels Blockguss hergestellt werden. Dabei wird eine Siliciumschmelze in Form einer Rundsäule oder eines großen Quaders kristallisiert und danach in einzelne Scheiben gesägt. Dieser hohe Anteil wird sich vermutlich durch neue Fertigungskapazitäten in den kommenden Jahren deutlich erhöhen, da viele Hersteller die langjährig bewährten Produktionstechniken auf der Basis kristalliner Siliciumscheiben gegenüber neuen Technologien vorziehen.

Als zukünftige Alternativen zu den Solarzellen aus Siliciumscheiben (typische Dicke ca. 300 µm) werden derzeit Dünnschichtsolarzellen diskutiert, die im Vergleich zu Solarzellen aus kristallinen Siliciumscheiben mit deutlich weniger Halbleitermaterial auskommen (Dicke ca. 1-10 µm). Diese Zellen können mit unterschiedlichen Verfahren direkt auf große Glasflächen aufgebracht werden und versprechen daher deutliche Kostenreduktionspotenziale. Bereits kommerziell verfügbar sind amorphe Silicium-Dünnschichtsolarzellen mit Wirkungsgraden im Bereich 6-8%. Höhere Wirkungsgrade können mit Verbindungshalbleitern wie CdTe oder CuInS₂ erzielt werden. Solarzellen aus diesen Materialien werden derzeit im Rahmen von Pilotfertigungslinien erprobt (A. Abken et al., Proc. 16. EPVSEC, 2000; D. Cunningham et al., Proc. 16. EPVSEC, 2000). Ob sich diese Materialien langfristig durchsetzen können ist zur Zeit noch unklar, da diese teilweise toxisch oder nur in geringen Mengen verfügbar sind. Große Hoffnungen werden auf materialsparende kristalline Si-Dünnschichtsolarzellen gesetzt, da Silicium umweltverträglich und unbegrenzt verfügbar ist. Diese Zellen sind jedoch noch in einem sehr frühen Stadium (R. Brendel et al., Proc. 14. EPVSEC, S. 1354, 1997; K. Feldrapp et al., Proc. 16. EPVSEC, 2000).

Eine zweite Alternative zur konventionellen Herstellung von Solarzellen aus kristallinen Siliciumscheiben ist die Verwendung von Siliciumfolien. Dabei wird Silicium direkt in der für Solarzellen erforderlichen Dicke als Folie kristallisiert. Dies vermeidet die beträchtlichen Schnittverluste der klassischen Blockguss- oder Czochralski-Methoden. Bereits industriell angewendet wird das sogenannte Edge-defined Film-fed Growth (EFG) Verfahren, welches die Herstellung qualitativ sehr hochwertiger Siliciumfolien ermöglicht. Neueste Entwicklungen zielen auf die Reduzierung der Foliendicke auf ca. 100 µm. Im Gegensatz zu den Blockguss- oder Czochralski-Methoden ist mit den Folienverfahren eine deutliche Reduzierung der Herstellungskosten möglich, da hierbei mit dünner werdenden Scheiben das Verhältnis Schnittverlust zu Scheibenvolumen nicht zunimmt. Daher könnten Siliciumfolien evtl. während des langfristigen Übergangs von der bestehenden Scheiben- zur Dünnschicht-Technologie den Markt dominieren.

Eine zentrale Größe aller Silicium-Solarzellen ist die effektive Lebensdauer der durch Licht generierten Ladungsträger im Kristallvolumen. Diese muß ausreichend hoch sein, damit möglichst alle Ladungsträger zu den Metallkontakten diffundieren und damit in den angeschlossenen Stromkreis gelangen können. Dies gilt sowohl für die derzeit dominierenden Blockguss- und Czochralski-Scheiben, für die mittelfristig vermutlich vermehrt zum Einsatz kommenden Siliciumfolien als auch für die evtl. zukünftig möglichen kristallinen Silicium-Dünnschichtsolarzellen.

Die effektive Ladungsträger-Lebensdauer von kristallinem Silicium wird durch Kristallfehler (Versetzungen oder Fehlstellen), durch Kristallverunreinigungen (u.a. Metallatome) und durch die Beschaffenheit der Kristalloberfläche (z.B. freie Bindungen) begrenzt. Eine ausreichende Vermeidung von Kristallfehlern und -verunreinigungen sowie die Herstellung einer idealen Oberfläche bereits während der Kristall- und Scheibenherstellung ist auf Grund technologischer Hindernisse oder aus wirtschaftlichen Gründen nicht möglich. Es wird deshalb versucht, in den nachgeschalteten Solarzellen-Herstellungsprozessen die ursprünglich oft schlechte Ladungsträger-Lebensdauer der Siliciumscheiben zu verbessern. Dies ist durch eine nachträgliche Reduktion der Verunreinigungen (Gettern) (L. J. Caballero et al., Proc. 16. EPVSEC 2000), durch elektronisches "Entschärfen" von Kristalldefekten durch Einbringen von atomarem Wasserstoff in den Kristall (Wasserstoff-Volumenpassivierung) (B.L. Sopori et al., Solar En. Mat. & Solar Cells 41/42, S. 159, 1996) und durch Aufbringen von Oberflächenbeschichtungen zur Verhinderung von Ladungsträgerrekombination an der Oberfläche (elektronische Oberflächenpassivierung) (A. Aberle, R. Hezel, Progr. in PV 5, S. 29 (1997) möglich. Diesbezügliche Prozesse können von entscheidender Bedeutung für gute Solarzellenwirkungsgrade sein und werden daher in verschiedenen Ausführungsarten bereits industriell angewandt.

Zur Wasserstoff-Volumenpassivierung von Siliciumsolarzellen sind u.a. die Verfahren Wasserstoffplasma, Temperung in Formiergas und Eindiffusion von Wasserstoff aus einer wasserstoffhaltigen Siliciumnitridoberflächenschicht (SiN) bekannt. Zur elektronischen Oberflächenpassivierung sind u. a. die Verfahren Oxidation der Siliciumoberfläche (S. Wenham et al., Solar En. Mat. & Solar Cells 65, S. 377, 2001) und Aufbringen einer wasserstoffhaltigen Siliciumnitridoberflächenschicht (A. Aberle, R. Hezel, Progr. in PV 5, S. 29 (1997) bekannt. Unter allen bekannten Verfahren ist die Anwendung einer wasserstoffhaltigen SiN-Oberflächenschicht das einzige, welches beide Prozesse gleichzeitig realisieren kann. Aus diesem Grund setzen immer mehr Solarzellenhersteller SiN-Schichten in ihrer Produktion ein. Ein weiterer Vorteil von SiN-Oberflächenbeschichtungen ist, dass sie zusätzlich zu ihren Passiviereigenschaften ausgezeichnete optische Parameter besitzen, wodurch sie als effektive Antireflexionsbeschichtungen verwendet werden können.

Die Wasserstoff-Volumenpassivierung mit Hilfe einer SiN-Oberflächenbeschichtung findet in zwei Prozessschritten statt. Zunächst wird die wasserstoffhaltige SiN-Schicht auf die Oberfläche der Siliciumscheibe aufgebracht. Dabei kann bereits ein geringer Anteil von atomarem Wasserstoff in einen oberflächennahen Bereich der Siliciumscheibe eindringen. Danach erfolgt eine Hochtemperaturbehandlung bei Temperaturen oberhalb von 700 °C. Bei diesen hohen Temperaturen wird eine relativ große Menge an atomarem Wasserstoff in der Oberflächenschicht frei und diffundiert tief in den Siliciumkristall ein (B.L. Sopori et al., Solar En. Mat. & Solar Cells 41/42, S. 159, 1996; J. Jeong et al., J. Appl. Phys. 87 (10), S. 7551, 2000). Die elektronische Oberflächenpassivierung mit Hilfe einer SiN-Oberflächenbeschichtung erfolgt durch zwei Effekte. Erstens lagert sich der in der Schicht enthaltene Wasserstoff an die Siliciumoberfläche an und passiviert freie Siliciumbindungen, so dass diese elektronisch unwirksam werden. Zweitens entstehen in der Schicht feste Isolatorladungen, die durch Influenz im Silicium ein elektrisches Feld erzeugen, welches zu einer Verstärkung des elektronischen Passiviereffektes führt (Ladungsträger werden von der Oberfläche ferngehalten und können dadurch dort nicht verloren gehen) (A. G. Aberle et al., Solar En. Mat. & Solar Cells 29, S. 175, 1993). Die für Solarzellenanwendungen bekannten Herstellverfahren von SiN-Oberflächenbeschichtungen sind:
a) Parallelplattenplasma:
   Bei diesem Verfahren werden silicium- und stickstoffhaltige Prozessgase, vorzugsweise Silan und Ammoniak, in einer Niederdruckanlage durch eine Plasmaentladung angeregt und zur Reaktion gebracht. Die Plasmaentladung wird zwischen zwei parallelen Platten durch Anlegen einer Wechselspannung erzeugt. Diese liegt typischerweise im kHz oder MHz-Frequenzbereich mit einer Spannung von 100 bis 1000 V (R. Reif, in: Handbook of Plasma Processing Technology, Noyes, New Yersey, 1990, S. 269 ff.).
b) Remote-Mikrowellen-Plasma
   Ammoniak oder Stickstoff werden in einem Niederdruck-Plasma außerhalb oder in einem abgetrennten Bereich der Beschichtungskammer angeregt und dann zum Substrat geleitet. Auf dem Weg dorthin wird ein siliciumhaltiges Prozessgas (in der Regel Silan) zugemischt. Das angeregte stickstoffhaltige Gas reagiert dabei mit dem siliciumhaltigen Gas, so dass es zu einer Schichtabscheidung auf dem Substrat kommt.
c) LPCVD
   Stickstoff- und siliciumhaltige Prozessgase werden in einer Niederdruckanlage bei Temperaturen über 700 °C thermisch zur Reaktion gebracht. Auf Grund der erforderlichen hohen Temperaturen ist dieses Verfahren mit mehreren Nachteilen behaftet. U.a. können temperaturempfindliche Substrate nicht prozessiert werden und der Wasserstoffgehalt der SiN-Schichten ist gering, da bei diesen Temperaturen der Großteil von Wasserstoff aus der Schicht effundiert.

Für die Oberflächenbeschichtung von Solarzellen zur Wasserstoff-Volumenpassivierung und elektronischen Oberflächenpassivierung mit SiN werden bisher ausschließlich Parallelplatten-SiN- und Remote-Mikrowellen-SiN-Schichten angewendet (A. G. Aberle, Solar En. Mat. & Solar Cells 65, S. 239, 2001). Beide Verfahren besitzen die Nachteile, dass die Wirksamkeit der SiN-Schichten in hohem Maße von der Schichtzusammensetzung und den Abscheideparametern abhängig ist (T. Lauinger et al., J. Vac. Sci. Technol. A 16 (2), S. 530, 1998). Dadurch entstehen die folgenden Probleme:
- nicht ausreichend hohe Solarzellenwirkungsgrade, da die verwendeten Schichten das mögliche Potential für Wasserstoff-Volumenpassivierung und elektronische Oberflächenpassivierung nicht ausschöpfen;
- während der Prozesseinführung werden aufwendige Optimierungsexperimente zur Bestimmung der möglichen Parameterfenster notwendig;
- im Betrieb sind aufwendige Prozesskontrollen erforderlich, um eine gleichbleibende Qualität der Schichten zu ermöglichen;
- die engen Parameterfenster, in denen eine gute Volumenpassivierung möglich ist, schränken die Variationsmöglichkeiten der Schichtherstellung ein, so dass die Schichten nicht gleichzeitig in Bezug auf ihre Antireflexions- und Oberflächenpassivierqualitäten optimiert werden können;
- durch das insgesamt sensible Verfahren und den hohen Kontrollaufwand wird das Wirtschaftlichkeitspotenzial nicht ausgeschöpft.

Aus Appl. Phys. Lett. 71(10), p. 1371, 1372, Izumi, Matsumara, "Low-temperature nitridation of silicon surface NH₃-decomposed species in a catalytic chemical vapor deposition system" ist ein Verfahren zur Nitrierung von Silicium-Oberflächen von Halbleiterelementen (ULSI) bekannt. Auf der Oberfläche ausgebildete SiNₓO_{y}-Schichten weisen ein Stöchiometrieverhältnis von Si:N:O = 1:0,9:0,3 bei einer maximalen Dicke von 4,8 nm auf. Die Schicht wird im CAT-CVD-Verfahren mit Wolframdraht als Katalysator hergestellt. Messungen haben ergeben, dass durch Wolfram bedingte Verunreinigungen der SiNₓO_{y}-Schicht vernachlässigbar sind. Eine entsprechende Nitrierung für Solarzellen zu nutzen, ist aufgrund der geringen Schichtdicke des SiNₓO_{y} ungeeignet.

Um photovoltaisch aktive Schichten für eine Solarzelle auszubilden, kann poly-Si im Cat-CVD-Verfahren abgeschieden werden (Solar Energy Materials & Solar Cells 69 (2001) 107-114, Niira et al., "Thin film poly-Si formation for solar cells by Flux method and Cat-CVD method"). In den poly-Si-Schichten treten Metallverunreinigungen in einer Konzentration von 2 x 10¹⁴ cm⁻³ bis 2x10¹⁸cm⁻³ auf.

In Solar Energy Materials & Solar Cells, Vol. 65, S. 541-547, Schropp et al., "Poly-silicon films with low impurity concentration made by hot wire chemical vapour deposition" wird beschrieben, dass poly-Si mittels HWCVD abgeschieden werden. Verunreinigungen von Wolfram in einer Konzentration von 10¹⁶cm³ konnten festgestellt werden.

Aus der US 6,225,241 B1 ist ein Verfahren zur katalytischen Abscheidung einer Passivierungsschicht auf einem Halbleitersubstrat bekannt.

Der vorliegenden Erfindung liegt das Problem zu Grunde, ein Verfahren zur Herstellung einer Solarzelle derart weiterzubilden, dass neben guten optischen Eigenschaften sowohl eine gute Oberflächen- als auch Volumenpassivierung des Substrats möglich wird. Dabei soll eine wirtschaftliche Herstellung bei guter Reproduzierbarkeit möglich sein. Insbesondere soll eine gute Volumenpassivierung bei weiten Parameterfenstern durchführbar sein, um gleichzeitig gewünschte Antireflexions- bzw. Oberflächenpassivierungsschichten zu erreichen.

Erfindungsgemäß wird das Problem im Wesentlichen dadurch gelöst, dass beim Ausbilden der Silicium enthaltenden Schicht in Form von SiNₓO_{y} mit 0 < x ≤ 1,5 und 0 ≤ y ≤ 2 gezielt in dieser ein oder mehrere katalytisch wirkende Dotierstoffe mit einer Konzentration C mit 1 x 10¹⁴ cm⁻³ ≤ C ≤ 10²¹ cm⁻³ eingelagert werden. Die Dotierstoffe setzen aus der SiNₓO_{y}-Schicht Wasserstoff frei und/oder beeinflussen die Struktur der Schicht derart, dass diese vermehrt Wasserstoff abgeben kann. Insbesondere wird die SiNₓO_{y}-Schicht mit Mittelwerten über ihre Schichtdicke von 0,1 < x < 1,5 und 0,01 < y < 2 ausgebildet.

Bevorzugterweise sollte sich die Konzentration C belaufen zwischen 10¹⁶ cm⁻³ und 10¹⁹ cm⁻³.

In hervorzuhebender Weise handelt es sich bei dem bzw. den Dotierstoffen um solche, die aus der Gruppe V und VI des Periodensystems bzw. der Reihe der Refraktärmetalle stammen oder diese enthalten. Als bevorzugte Dotierstoffe sind dabei Molybdän, Tantal, Wolfram, Platin und/oder Rhenium zu nennen.

Dabei ist als Dotierstoff insbesondere elementarer Wolfram und/oder WOₓ mit 0 ≤ x ≤ 4 hervorzuheben, welche durch Keimbildung die Struktur der aufwachsenden SiNₓO_{y}-Schicht besonders günstig beeinflussen und durch katalytische Wirkung die Aktivierung von in der Schicht enthaltenem Wasserstoff bewirken, so dass im gewünschten Umfang sowohl eine Volumen- als auch eine Oberflächenpassivierung des aus Silicium bestehenden oder dieses enthaltenden Substrates erfolgt.

Erfindungsgemäß wird eine wasserstoffhaltige SiNₓO_{y}-Schicht gewählt, die während des Wachstums und beim Tempern Wasserstoff freisetzt. Die Schicht wird mit einem oder mehreren Dotierstoffen versehen, welche als Katalysator während des Schichtwachstums zu einem verbesserten strukturellen Einbau von Wasserstoff, zu einer Abspaltung von atomarem Wasserstoff (Protonen) aus wasserstoffhaltigen Molekülen oder aus molekularem Wasserstoff oder während des Temperns der Schicht zu einer Abspaltung von atomarem Wasserstoff aus dem Atomverband der Schicht führen.

Parallel zur Oberflächen- bzw. Volumenpassivierung bildet sich bei der Oberflächenbeschichtung des Substrats der Solarzelle eine Antireflexionsschicht aus.

Abweichend von der bisher herrschenden Meinung werden gezielt beim Ausbilden einer SiNₓO_{y}-Schicht einer Solarzelle insbesondere metallische Dotierstoffe eingelagert, die ansonsten als Kontamination bewertet wurden und bei der Herstellung von Halbleiterbauelementen zu einer Verschlechterung der Qualität führen. Überraschenderweise ergibt sich aufgrund der erfindungsgemäßen Lehre, also dem gezielten Einlagern von insbesondere aus einem oder mehreren Refraktärmetallen bestehenden Dotierstoffen eine Verbesserung von Solarzelleneigenschaften, und zwar sowohl durch eine Volumenpassivierung als auch eine Oberflächenpassivierung mit Wasserstoff. Dabei hat sich gezeigt, dass eine einfache Prozesskontrolle möglich ist, ohne dass Einbußen in Bezug auf Reproduzierbarkeit bzw. Qualität in Kauf genommen werden müssen.

Auch ergibt sich der Vorteil weitere Parameterfenster, in denen eine gute Oberflächen- und Volumenpassivierung möglich ist, so dass Variationsmöglichkeiten der Schichtherstellung nicht eingeschränkt werden und damit eine gleichzeitige Optimierung der Schichten in Bezug auf ihre Antireflexions- und Oberflächenpassivierqualität möglich wird.

Die Wirksamkeit der Dotierung des bzw. der Dotierstoffe kann durch Struktur und Dicke der wasserstoffhaltigen Siliciumnitridschicht und/oder Gradienten der Dotierkonzentration des bzw. der Dotierstoffe über die Schichtdicke beeinflusst werden.

Bei homogen ausgebildeter SiNₓO_{y}-Schicht sollte die Stöchiometrie x zwischen 0,1 und 1,5 bei Schichtdicken im Bereich zwischen 50 nm und 100 nm liegen.

Die homogene Oberflächenschicht zu realisieren, bereitet jedoch häufig Probleme, da es insbesondere am Übergang zwischen Substrat und Oberflächenschicht durch den Einfluss der Substratoberfläche zu Strukturänderungen in der Oberflächenschicht kommt. Daher sieht eine Weiterbildung der Erfindung vor, dass eine gezielte Veränderung der Stöchiometrie der SiNₓO_{y}-Schicht derart erfolgt, dass über die Schichtdicke x zwischen 0,1 und 1,5 und/oder y zwischen 0 und 2,0 variiert, wobei vorzugsweise x mit der Schichtdicke im Bereich zwischen 0,6 und 1,3 zunimmt und y mit der Schichtdicke im Bereich zwischen 0,1 und 1,0 zunimmt.

Kann erwähntermaßen die Dotierung der Dotierstoffe homogen gewählt werden, so ist auch eine Gradientenausbildung über die Schichtdicke möglich, wobei insbesondere die Konzentration der Dotierstoffe mit zunehmender Schichtdicke im Bereich 1 x 10¹⁵ cm-3 bis 1 x 10¹⁸ cm⁻³ zunimmt.

Die gezielte Ausbildung von Oberflächenschichten mit starken Gradienten und variabler Dikke hat unter anderem den Vorteil einer verbesserten Antireflexionseigenschaft der Silicium-Nitrid-Schicht.

Die erfindungsgemäße Lehre kann für alle Arten von Oberflächenschicht, d. h. ohne oder mit Gradienten und mit unterschiedlicher Dicke realisiert werden. Erwähntermaßen besteht auch die Möglichkeit, die Dotierkonzentration mit einem Gradienten über die Schichtdicke herzustellen, so dass eine Anpassung an verschiedene Oberflächenschichtsysteme möglich ist.

Ein mögliches Verfahren zur Dotierung von SiNₓO_{y}-Schichten mit Refraktärmetallen ist das Verfahren der katalytischen Abscheidung von Silicium-Nitrid durch Anregung von wasserstoffhaltigem Silicium- und Stickstoff-Verbindungen wie Silan-, Disilan-, Ammoniak-, Wasserstoff- oder Hydrazin-Gasen in Niederdruckanlagen an heißen Refraktärmetallen in Form von Flachmetallen oder Drähten wie Tantal, Molybdän, Wolfram, Rhenium, Platin und/oder Niob.

Zwar ist es bekannt, entsprechende Verfahren zur Abscheidung von Diamantschichten einzusetzen. Auch Prozesse zur Abscheidung von amorphem Silicium für Solarzellen und Prozesse zur Abscheidung von Siliciumnitrid als chemische mechanische Passivier-, also Schutzschicht für integrierte Halbleiterbauelemente sind bekannt. Allerdings wurde bei der Ausbildung entsprechender Schutzschichten für Halbleiterbauelemente darauf geachtet, dass eine Kontamination durch Metalle ausgeschlossen wird, da andernfalls die Qualität des Halbleiterbauelementes nachteilig beeinflusst werden würde (H. Matsumura, Jpn. J. Appl. Phys. 37, S. 3175, 1998).

Insbesondere sieht die Erfindung vor, wasserstoffhaltige dotierte Oberflächenschichten auf großflächige Siliciumsubstrate abzuscheiden. Dabei kann das großflächige Siliciumsubstrat als dünne Siliciumschicht auf einem Trägermaterial aufgebracht werden. Als Trägermaterial kommt eine Glasscheibe, eine Keramikplatte, ein Metallblech oder eine Polymerfolie in Frage. Das Siliciumsubstrat selbst kann eine mikrokristalline, amorphe oder multikristalline Kristallstruktur aufweisen.

Auch besteht die Möglichkeit, das großflächige Siliciumsubstrat aus einer monokristallinen oder multikristallinen Siliciumscheibe oder aus einer Silicium-Folie auszubilden. Insbesondere kommt als Siliciumfolie eine solche in Frage, die nach dem EFG-Verfahren (Edge-defined Film-fed Growth) hergestellt wird. Unabhängig hiervon kann das großflächige Siliciumsubstrat einen p-n-Übergang aufweisen.

Durch Einstellen von Beschichtungsparametern wie Druck, Temperatur des Dotierstoff-Metalls, Gaszusammensetzung, Sauerstoffpartialdruck, Substrattemperatur, Abstand zwischen Metall und Substrat und Metallgeometrie kann eine gewünschte Dotierung der SiNₓO_{y}-Schicht mit dem Dotierstoff wie insbesondere einem Refraktärmetall erfolgen. Insbesondere sollten die Abscheiderparameter in den Bereichen liegen:

| | |
|---|---|
| Druck P | 0,1 Pa≤P≤ 1000 Pa |
| Metalltemperatur T | 1500 °C ≤ T ≤ 2500 °C |
| Gaszusammensetzung (Verhältnis siliciumhaltige zu stickstoffhaltige Reaktionsgase) | 0,001 - 1,0 |
| Sauerstoffpartialdruck | 0 - 20 Pa |
| Substrattemperatur | 20 °C - 600 °C |
| Abstand : Metall-Substrat | 1 - 100 mm |
| Geometrie des Metalls | Stab, Draht oder Platte. |

Um die SiNₓO_{y}-Schicht mit der gezielten Dotierung der Dotierstoffe auszubilden, kann ein kontinuierlicher oder ein statischer Betrieb erfolgen. Ersteres bedeutet, dass das Substrat bei ausgeschalteter Beschichtungsquelle, die aus Heißmetall sowie Gas-Zu- und -Abführung besteht, in den Beschichtungsbereich eingebracht wird, wobei das Ausbilden der Schicht bei stillstehendem Substrat erfolgt. Alternativ besteht die Möglichkeit, getaktet zu beschichten, das bedeutet, dass bei betriebener Beschichtungsquelle Substrate in den Beschichtungsbereich eingebracht, dort beschichtet und sodann wieder entfernt werden. Schließlich ist ein kontinuierlicher Durchlaufprozess möglich, bei dem die Substrate kontinuierlich in den Beschichtungsbereich eingebracht, durch diesen geführt und aus diesem entfernt werden.

Insbesondere kann eine Änderung der Stöchiometrie in der Schichtzusammensetzung von Siliciumnitrid durch Änderung der Parameter Gaszusammensetzung, Druck, Metalltemperatur und Gesamtgasfluss erfolgen, wobei die Stöchiometrie zwischen 0,1 und 1,5 variiert wird. Auch eine Änderung der Stöchiometrie in der Schichtzusammensetzung über die Schichtdikke durch zeitliche Änderung der Parametergaszusammensetzung, Druck, Metalltemperatur und Gesamtgasfluss während einer statischen Beschichtung ist möglich. Auch durch räumliche Änderung der Parameter Gaszusammensetzung, Druck, Metalltemperatur, Metallgeometrie und Gesamtgasfluss entlang der Beschichtungsstrecke ist eine gezielte Stöchiometrieeinstellung möglich. Die Zusammensetzung der Prozessgase ohne Durchflussrate (Closed-Chamber-Deposition) kann über die Reaktionsgeschwindigkeit der Abscheidung erfolgen.

Die aufgrund der erfindungsgemäßen Lehre erzielbaren Vorteile sollen anhand der nachstehenden Tabelle verdeutlicht werden. So konnte bei der Herstellung von EFG-Solarzellen mit wasserstoffhaltigen SiNₓO_{y}-Oberflächenschichten überraschend eine Korrelation des Solarzellenwirkungsgrades (Eta) mit dem Gehalt von Wolfram als Dotierstoff in der SiNₓO_{y}-Schicht gefunden werden.

| Gruppe | Si | N | O | H | Fe | W | Eta |
|---|---|---|---|---|---|---|---|
| | [At%] | [At%] | [At%] | [At%] | [At%] | [At%] | [%] |
| 1 | 37 | 47 | 1,1 | 15 | - | - | 13,34 |
| 2 | 37 | 51 | 1,1 | 12 | - | - | 13,45 |
| 3 | 37 | 50 | 1,8 | 11 | 0,008 | - | 13,50 |
| 4 | 37 | 48 | 1,6 | 13 | 0,007 | 0,020 | 14,04 |
| 5 | 36 | 50 | 2,1 | 12 | 0,002 | - | 13,38 |

Wie die Tabelle zeigt, besitzen alle Gruppen vergleichbare Silicium-, Stickstoff- und Wasserstoffkonzentrationen. Signifikante Variationen sind in den Sauerstoff-, Eisen- und Wolframkonzentrationen zu beobachten. Sowohl eine erhöhte Sauerstoff- (Gruppe 5) als auch eine erhöhte Eisenkonzentration (Gruppe 3) in den SiN Schichten führt zu keiner Verbesserung des Solarzellenwirkungsgrades im Vergleich zu den Referenzgruppen mit niedrigen Verunreinigungsgehalten (Gruppen 1 und 2). Alle diese Gruppen besitzen Wirkungsgrade zwischen 13,34 % und 13,50 %. Dagegen korreliert die in der Gruppe 4 nachgewiesene erhöhte Wolframkonzentration deutlich mit einem um 0,6 % absolut höheren Wirkungsgrad der Solarzellen von 14.04 %.

Ergibt sich für die Gruppe 4 eine Wolfram-Konzentration von ca. 10¹⁹ cm⁻³, so ist anzumerken, dass ein Effekt bereits bei sehr viel niedrigeren Konzentrationen auftritt, da Wasserstoff sehr gut diffundieren kann und somit wenige Fremdatome zu einer hohen Anzahl von aktivierten Wasserstoffatomen führen. Eine untere Grenze der Wirksamkeit einer Fremdstoff-Dotierung dürfte in der Größenordnung von 10¹⁴ bis 10¹⁵ cm⁻³ liegen.

Die Ursachen für die besseren Wirkungsgrade der Solarzellen mit W-dotierter SiNₓO_{y}-Schicht können möglicherweise auf drei Mechanismen beruhen. Erstens können die Wolfram-Atome während der Herstellung der Schichten als Katalysator wirken und dadurch die ablaufenden Wachstumsreaktionen positiv beeinflussen (z. B. ist es denkbar, dass sich in Anwesenheit von Wolfram durch Aufspalten von molekularem Wasserstoff, N-H-Bindungen oder Si-H-Bindungen eine höhere Konzentration von atomarem Wasserstoff einstellt. Dies kann insbesondere zu einer verbesserten elektronischen Oberflächenpassivierung führen.).

Zweitens können die Wolfram-Atome während der nachgeschalteten Hochtemperaturbehandlung wiederum als Katalysator durch Aufspalten von molekularem Wasserstoff, N-H-Bindungen oder Si-H-Bindungen zu einer erhöhten Konzentration von atomarem Wasserstoff führen und dadurch insbesondere die Wasserstoff-Volumenpassivierung fördern.

Drittens können Wolfram-Atome während des Schichtwachstums zu einer Keimbildung von kristallinem Siliciumnitrid führen und dadurch zu einer positiven Strukturänderung der gesamten Schicht führen.

Aufgrund der Wolfram-Dotierung in der wasserstoffhaltigen Oberflächenbeschichtung erfolgt zusätzliche Aktivierung von Wasserstoff zur Volumen- und Oberflächenpassivierung. Anstelle von Wolfram kommen insbesondere auch alle Refraktärmetalle mit ähnlichen chemischen Eigenschaften wie Mo, Ta, Pt oder Re in Frage. Weiterhin sind alle Fremdatome oder Fremdmoleküle geeignet, die wie Wolfram zu einer zusätzlichen Aktivierung von Wasserstoff führen. Beispielhaft ist insbesondere Kohlenstoff zu nennen. Fremdatome im Sinne der Erfindung, die eine Oberflächen- und Volumenpassivierung bewirken, sind jedoch nicht Sauerstoff und Wasserstoff.

Zur Herstellung von Solarzellen müssen die dotierten wasserstoffhaltigen Oberflächenschichten großflächig auf die je nach Solarzellentyp unterschiedlichen Siliciumsubstrate abgeschieden werden. Dazu kann die in industriellem Maßstab verfügbare Parallelplattentechnik verwendet werden, falls entsprechende Gaszusätze benutzt werden, die zu einer Abscheidung der gewünschten Fremdatome in den aufgebrachten Schichten führen. Da diese Beschichtungsverfahren bereits für sehr unterschiedliche Substrattypen entwickelt wurden, ist die Abscheidung der dotierten Schichten auf alle diese Substrattypen und damit auch auf Solarzellen aus dünnen Siliciumschichten, die diese Trägermaterialien nutzen, möglich. Als Trägermaterialien kommen dabei Glasscheiben, Keramikplatten, Metallbleche oder Polymerfolien in Betracht. Mit substratunabhängigen Beschichtungsverfahren wie der Remote-Mikrowellenplasma- oder der LPCVD-Technik können dotierte wasserstoffhaltige Schichten prinzipiell auf alle Arten von Substraten abgeschieden werden.

Somit ist die erfindungsgemäße Lehre für alle Arten von großflächigen Halbleiterbauelementen, insbesondere jedoch von Silicium-Solarzellen mit mikrokristalliner, amorpher oder multikristalliner Kristallstruktur in Form von Folien (z. B. EFG), Scheiben oder dünnen Schichten auf einem Trägermaterial geeignet. Insbesondere ist die Eignung für die Passivierung großflächiger pn-Übergänge gegeben.

Die Erfindung wird nachstehend anhand von Ausführungsbeispielen näher erläutert:

### Beispiel 1:

Ausgangsmaterial ist eine 100 mm x 100 mm große Bor-dotierte Siliciumscheibe der Dicke 300 µm mit einer Leitfähigkeit von ca. 5 Ωcm und einer einseitigen Phosphordiffusion mit einem Emitterschichtwiderstand von ca. 40 Ω/sq.

Diese Scheibe wird in eine Vakuumkammer eingebracht und bei einem Druck von weniger als 5 x 10⁻³ mbar auf 300 °C erwärmt. Die Scheibe liegt in der Vakuumkammer auf einer horizontalen, mit Heizwendeln ausgestatteten Edelstahlplatte. Ca. 100 mm oberhalb der Scheibe befindet sich ein vertikal durch die Wandung der Vakuumkammer durchtretendes Quarzglasrohr mit einem Durchmesser von 20 mm.

Nach dem Aufwärmen der Scheibe wird durch das Quarzglasrohr Ammoniak in die Kammer eingeleitet. Ca. 20 mm seitlich des Quarzrohres befindet sich ein weiterer Gaseinlass, durch welchen Silan über eine Verteilerdüse in die Kammer eingeleitet wird. Das Mischungsverhältnis der Gase beträgt 1:2 (Silan : Ammoniak). Der Druck in der Kammer wird durch ein Stellventil im Gasauslass auf 3 x 10⁻² mbar geregelt.

Das Quarzglasrohr ist außerhalb der Vakuumkammer von einem Mikrowellenresonator umgeben. In diesen werden 120 W Mikrowellenleistung (Frequenz 2,54 GHz) eingekoppelt, wodurch sich innerhalb des Glasrohres ein Ammoniak-Plasma ausbildet. Direkt am Ausgang des Quarzglasrohres befindet sich eine Platinwendel, die auf ca. 1900 °C geheizt wird und von dem im Quarzglasrohr angeregten Ammoniak überströmt wird.

Der angeregte Ammoniak reagiert mit dem Silan zu Silciumnitrid, welches sich auf der Siliciumscheibe abscheidet. Von der beheizten Platinwendel dampfen Platinatome ab, die in die Siliciumschicht eingebaut werden und so zu einer Dotierung der Schicht gemäß der Erfindung führen. Der Beschichtungsprozess wird solange ausgeführt, bis sich eine Dicke der Siliciumnitridschicht von 75 nm einstellt.

Die Weiterverarbeitung der auf diese Weise beschichteten Wafern zu Solarzellen führt zu Wirkungsgraden größer 14,5 %.

### Beispiel 2:

Ausgangsmaterial ist eine 100 mm x 100 mm große Bor-dotierte Siliciumscheibe der Dicke 300 µm mit einer Leitfähigkeit von ca. 5 Ωcm und einer einseitigen Phosphordiffusion mit einem Emitterschichtwiderstand von ca. 40 Ω/sq.

Diese Scheibe wird in eine Vakuumkammer eingebracht und bei einem Druck von weniger als 5 x 10⁻³ mbar auf 300 °C erwärmt. Die Scheibe liegt in der Vakuumkammer auf einer horizontalen, mit Heizwendeln ausgestatteten kreisrunden Edelstahlplatte mit einem Durchmesser von 300 mm. Ca. 20 mm oberhalb der Scheibe befindet sich eine kreisrunde Edelstahlplatte mit einem Durchmesser von 300 mm, welche gleichmäßig verteilte Gasauslassöffnungen mit einem Durchmesser von 0,5 mm enthält.

Nach dem Aufwärmen der Siliciumscheibe wird durch die obere Edelstahlplatte Ammoniak, Silan und Methan eingeleitet. Das Mischungsverhältnis der Gase beträgt 1:2:0,001 (Silan:Ammoniak:Methan). Der Druck in der Kammer wird durch ein Stellventil im Gasauslass auf 5 x 10⁻² mbar geregelt.

Zwischen der unteren und der oberen Edelstahlplatte wird eine Wechselspannung von 700 V (Frequenz 100 kHz) angelegt, so dass sich zwischen den beiden Platten ein Plasma ausbildet.

Der angeregte Ammoniak reagiert mit dem Silan zu Siliciumnitrid, welches sich auf der Siliciumscheibe abscheidet. Die Methan-Moleküle reagieren mit den Plasma-Radikalen derart, dass Kohlenstoff in die Siliciumschicht eingebaut wird und so zu einer Dotierung der Schicht gemäß der Erfindung führt. Der Beschichtungsprozess wird solange ausgeführt, bis sich eine Dicke der Siliciumnitridschicht von 75 nm einstellt.

Die Weiterverarbeitung der auf diese Weise beschichteten Wafern zu Solarzellen führt zu Wirkungsgraden größer 14,6 %.

## Patentansprüche

1. Verfahren zur Herstellung einer Solarzelle unter Ausbildung einer wasserstoffhaltigen Silicium enthaltenden Schicht in Form einer Passivierungs- und/oder Antireflexionsschicht auf einem aus Silicium bestehenden oder dieses enthaltenden Substrat wie Scheibe oder Folie,
**dadurch gekennzeichnet,**
**dass** beim Ausbilden der Silicium enthaltenden Schicht in Form von SiNₓO_{y} mit 0 < x ≤ 1,5 und 0 ≤ y ≤ 2 gezielt in dieser ein oder mehrere katalytisch wirkende Dotierstoffe mit einer Konzentration C mit 1 x 10¹⁴ cm⁻³ ≤ C ≤ 1 x 10²¹ cm⁻³ eingelagert werden, die aus der SiNₓO_{y}-Schicht Wasserstoff freisetzen und/oder die Struktur der Schicht zur vermerhten Abgabe von Wasserstoff beeinflussen.

2. Verfahren nach Anspruch 1,
**dadurch gekennzeichnet,**
**dass** die SiNₓO_{y}-Schicht mit Mittelwerten über ihre Schichtdicke von 0,1 < x < 1,5 und 0,01 < y < 2 ausgebildet wird.

3. Verfahren nach Anspruch 1,
**dadurch gekennzeichnet,**
**dass** der bzw. die Dotierstoffe mit einer Konzentration C mit 1 x 10¹⁶ cm⁻³ ≤ C ≤ 1 x 10¹⁹ cm³ eingelagert werden.

4. Verfahren nach zumindest einem der vorhergehenden Ansprüche,
**dadurch gekennzeichnet,**
**dass** der Dotierstoff bzw. die Dotierstoffe mit einem Gradienten über Dicke der SiNₓO_{y}-Schicht eingelagert werden, wobei insbesondere die Konzentration C des bzw. der Dotierstoffe mit zunehmender Schichtdicke im Bereich zwischen 1 x 10¹⁴ cm⁻³ und 1 x 10¹⁹ cm⁻³ zunimmt.

5. Verfahren nach zumindest einem der vorhergehenden Ansprüche,
**dadurch gekennzeichnet,**
**dass** der bzw. die Dotierstoffe in der SiNₓO_{y}-Schicht homogen verteilt eingelagert werden.

6. Verfahren nach zumindest einem der vorhergehenden Ansprüche,
**dadurch gekennzeichnet,**
**dass** als Dotierstoff bzw. Dotierstoffe Atome aus der Reihe der Refraktärmetalle oder diese enthaltend verwendet werden.

7. Verfahren nach zumindest einem der vorhergehenden Ansprüche,
**dadurch gekennzeichnet,**
**dass** als Dotierstoff Molybdän, Tantal, Wolfram, Platin, Rhenium oder Kohlenstoff oder Verbindungen dieser verwendet werden.

8. Verfahren nach zumindest einem der vorhergehenden Ansprüche,
**dadurch gekennzeichnet,**
**dass** das Substrat auf einer Glasscheibe, einer Keramikplatte, einem Metallblech oder einer Polymerfolie aufgebracht wird.

9. Verfahren nach zumindest einem der vorhergehenden Ansprüche,
**dadurch gekennzeichnet,**
**dass** das aus Silicium bestehende Substrat eine mikrokristalline, eine amorphe oder eine multikristalline Kristallstruktur aufweist.

10. Verfahren nach zumindest einem der vorhergehenden Ansprüche,
**dadurch gekennzeichnet,**
**dass** das Substrat aus einer monokristallinen oder multikristallinen Siliciumscheibe oder aus einer Siliciumfolie besteht.

11. Verfahren nach zumindest einem der vorhergehenden Ansprüche,
**dadurch gekennzeichnet,**
**dass** als Siliciumfolie eine nach dem EFG-Verfahren (Edge-defined Film-fed Growth) hergestellte Folie verwendet wird.

12. Verfahren nach zumindest einem der vorhergehenden Ansprüche,
**dadurch gekennzeichnet,**
**dass** als Dotierstoff elementares Wolfram und/oder WOₓ mit 0 ≤ x ≤ 3 verwendet wird.

13. Verfahren nach zumindest einem der vorhergehenden Ansprüche,
**dadurch gekennzeichnet,**
**dass** als Dotierstoff ein solcher verwendet wird, der zum Ausbilden der SiNₓO_{y}-Schicht verwendete Gase wie Silan, Disilan, Wasserstoff, Ammonium oder Hydrazin katalytisch zersetzt.

14. Verfahren nach zumindest einem der vorhergehenden Ansprüche,
**dadurch gekennzeichnet,**
**dass** die wasserstoffhaltige SiNₓO_{y}-Schicht aus amorphem hydrogenisiertem Siliciumnitrid besteht.

15. Verfahren nach zumindest einem der vorhergehenden Ansprüche,
**dadurch gekennzeichnet,**
**dass** die SiNₓO_{y}-Schicht homogen ausgebildet ist.

16. Verfahren nach zumindest einem der vorhergehenden Ansprüche,
**dadurch gekennzeichnet,**
**dass** die SiNₓO_{y}-Schicht über ihre Dicke variiert, wobei mit der Schichtdicke x im Bereich zwischen 0,6 bis 1,3 und y im Bereich zwischen 0,1 und 1,0 zunimmt.

17. Verfahren nach zumindest einem der vorhergehenden Ansprüche,
**dadurch gekennzeichnet,**
**dass** die SiNₓO_{y}-Schicht derart ausgebildet wird, dass deren Dicke im Bereich zwischen 30 nm und 150 nm, insbesondere im Bereich zwischen 50 nm und 110 nm liegt.

18. Verfahren nach zumindest einem der vorhergehenden Ansprüche,
**dadurch gekennzeichnet,**
**dass** die wasserstoffhaltige SiNₓO_{y}-Schicht durch Anregung von gasförmigen und wasserstoffhaltigen Silicium- und Stickstoffverbindungen, vorzugsweise Silan, Disilan, Wasserstoff, Ammoniak und Hydracin an heißen Refraktärmetalfen gebildet wird.

19. Verfahren nach zumindest einem der vorhergehenden Ansprüche,
**dadurch gekennzeichnet,**
**dass** die SiNₓO_{y}-Schicht in einem Reaktionsraum ausgebildet wird, in dem ein Druck P mit 0,1 Pa ≤ P ≤ 1000 Pa herrscht.

20. Verfahren nach zumindest einem der vorhergehenden Ansprüche,
**dadurch gekennzeichnet,**
**dass** der Druck P in der Reaktionskammer eingestellt wird auf 1 Pa ≤ P ≤ 200 Pa.

21. Verfahren nach zumindest einem der vorhergehenden Ansprüche,
**dadurch gekennzeichnet,**
**dass** die Dicke der wasserstoffhaltigen SiNₓO_{y}-Schicht durch Beschichtungsparameter wie Druck, Metalltemperatur, Gaszusammensetzung, Sauerstoffpartialdruck, Substrattemperatur, Abstand zwischen Metall und Substrat und/oder Metallgeometrie eingestellt wird.

22. Verfahren nach zumindest einem der vorhergehenden Ansprüche,
**dadurch gekennzeichnet,**
**dass** das den bzw. die Dotierstoffe bildende Metall auf eine Temperatur zwischen 1500 °C und 2500 °C eingestellt wird.

23. Verfahren nach zumindest einem der vorhergehenden Ansprüche,
**dadurch gekennzeichnet,**
**dass** die Gaszusammensetzung derart eingestellt wird, dass das Verhältnis zwischen siliciumhaltigem und stickstoffhaltigem Reaktionsgas sich beläuft auf 0,001 bis 1,0.

24. Verfahren nach zumindest einem der vorhergehenden Ansprüche,
**dadurch gekennzeichnet,**
**dass** der Sauerstoffpartialdruck eingestellt wird auf einen Wert p mit 0 < p ≤ 20 Pa.

25. Verfahren nach zumindest einem der vorhergehenden Ansprüche,
**dadurch gekennzeichnet,**
**dass** das Substrat auf eine Temperatur zwischen 20 °C und 600 °C eingestellt wird.

26. Verfahren nach zumindest einem der vorhergehenden Ansprüche,
**dadurch gekennzeichnet,**
**dass** der Abstand zwischen dem Metall und dem Substrat auf zwischen 1 mm und 100 mm eingestellt wird.

27. Verfahren nach zumindest einem der vorhergehenden Ansprüche,
**dadurch gekennzeichnet,**
**dass** als Metall ein solches mit einer Geometrie eines Stabes, eines Drahtes und/oder einer Platte verwendet wird.

28. Verfahren nach zumindest einem der vorhergehenden Ansprüche,
**dadurch gekennzeichnet,**
**dass** die wasserstoffhaltige SiNₓO_{y}-Schicht im statischen Beschichtungsbetrieb ausgebildet wird.

29. Verfahren nach zumindest einem der vorhergehenden Ansprüche,
**dadurch gekennzeichnet,**
**dass** die wasserstoffhaltige SiNₓO_{y}-Schicht im getakteten Beschichtungsbetrieb auf dem Substrat ausgebildet wird.

30. Verfahren nach zumindest einem der vorhergehenden Ansprüche,
**dadurch gekennzeichnet,**
**dass** die SiNₓO_{y}-Schicht auf dem Substrat im kontinuierlichen Durchlaufbeschichtungsbetrieb ausgebildet wird.

31. Verfahren nach zumindest einem der vorhergehenden Ansprüche,
**dadurch gekennzeichnet**
**dass** die Zusammensetzung der Prozessgase ohne Durchflussrate über Reaktionsgeschwindigkeit der Abscheidung eingestellt wird.

32. Verfahren nach zumindest einem der vorhergehenden Ansprüche,
**dadurch gekennzeichnet,**
**dass** Stöchiometriezusammensetzung der SiNₓO_{y}-Schicht durch Änderung der Parameter Gaszusammensetzung, Druck, Metalltemperatur und/oder Gesamtgasfluss eingestellt wird.

33. Verfahren nach zumindest einem der vorhergehenden Ansprüche,
**dadurch gekennzeichnet,**
**dass** Stöchiometrieänderung der Schichtzusammensetzung der SiNₓO_{y}-Schicht über deren Dicke durch zeitliche Änderung der Parameter Gaszusammensetzung, Druck, Metalltemperatur und/oder Gesamtgasfluss während der statischen Beschichtung eingestellt wird.

34. Verfahren nach zumindest einem der vorhergehenden Ansprüche,
**dadurch gekennzeichnet,**
**dass** Stöchiometrieänderung der Schichtzusammensetzung der SiNₓO_{y}-Schicht über die Schichtdicke durch räumliche Änderung der Parameter Gaszusammensetzung, Druck, Metalltemperatur, Metallgeometrie und/oder Gesamtgasfluss über Beschichtungsstrecke eingestellt wird.

## Claims

1. A method for producing a solar cell by formation of a hydrogenous layer containing silicon in form of a passivation and/or anti-reflexion layer on a substrate comprising or containing silicon such as a wafer or film,
**characterized in**
**that** during formation of the silicon containing layer in form of SiNₓO_{y} with 0 < x ≤ 1.5 and 0 ≤ y ≤ 2 one or more catalytically acting dopants with a concentration C of 1 x 10¹⁴ cm⁻³ ≤ C ≤ 1 x 10²¹ cm⁻³ are selectively added into the layer, said dopants setting free hydrogen from the SiNₓO_{y} layer and/or influencing the structure of the layer to increase the liberation of hydrogen.

2. Method according to claim 1,
**characterized in**
**that** the SiNₓO_{y} layer is formed with mean values over its layer thickness of 0.1 < x<1.5 and 0.01<y<2.

3. Method according to claim 1,
**characterized in**
**that** the dopant(s) is/are added in with a concentration C of 1 x 10¹⁶ cm⁻³ ≤ C < 1 x 10¹⁹ cm³.

4. Method according to at least one of the preceding claims,
**characterized in**
**that** the dopant or dopants are added in with a gradient over thickness of the SiNₓO_{y} layer, with the concentration C of the dopant(s) in particular increasing with increasing layer thickness in the range between 1 x 10¹⁴ cm⁻³ and 1 x 10¹⁹ cm⁻³.

5. Method according to at least one of the preceding claims,
**characterized in**
**that** the dopant or dopants is/are added into the SiNₓO_{y} layer homogenously distributed.

6. Method according to at least one of the preceding claims,
**characterized in**
**that** atoms from the range of refractory metals or containing these arc used as the dopant or dopants.

7. Method according to at least one of the preceding claims,
**characterized in**
**that** molybdenum, tantalum, tungsten, platinum, rhenium or carbon or compounds thereof are used as the dopant.

8. Method according to at least one of the preceding claims,
**characterized in**
**that** the substrate is deposited on a glass sheet, a ceramic plate, a metal sheet or a polymer film.

9. Method according to at least one of the preceding claims,
**characterized in**
**that** the substrate comprising silicon has a micro-crystalline, amorphous or multi-crystalline crystal structure.

10. Method according to at least one of the preceding claims,
**characterized in**
**that** the substrate comprises a mono-crystalline or multi-crystalline silicon wafer or a silicon film.

11. Method according to at least one of the preceding claims,
**characterized in**
**that** a film manufactured according to the EFG method (Edge-defined Film-fed Growth) is used as silicon film.

12. Method according to at least one of the preceding claims,
**characterized in**
**that** elementary tungsten and/or WOₓ with 0 ≤ x ≤ 3 is used as the dopant.

13. Method according to at least one of the preceding claims,
**characterized in**
**that** the dopant used is one which decomposes catalytically gases used for formation of the SiNₓO_{y} layer, such as silane, disilane, hydrogen, ammonia or hydrazine.

14. Method according to at least one of the preceding claims,
**characterized in**
**that** the hydrogenous SiNₓO_{y} layer comprises amorphous hydrogenized silicon nitride.

15. Method according to at least one of the preceding claims,
**characterized in**
**that** the SiNₓO_{y} layer is homogeneously formed.

16. Method according to at least one of the preceding claims,
**characterized in**
**that** the SiNₓO_{y} layer varies over its thickness, with x increasing with the layer thickness in the range between 0.6 and 1.3 and y in the range between 0.1 and 1.0.

17. Method according to at least one of the preceding claims,
**characterized in**
**that** the SiNₓO_{y} layer is formed such that its thickness is in the range between 30 nm and 150 nm, in particular in the range between 50 nm and 110 nm.

18. Method according to at least one of the preceding claims,
**characterized in**
**that** the hydrogenous SiNₓO_{y} layer is formed by the excitation of gaseous and hydrogenous silicon and nitrogen compounds, preferably silane, disilane, hydrogen ammonia and hydrazine on hot refractory metals.

19. Method according to at least one of the preceding claims,
**characterized in**
**that** the SiNₓO_{y} layer is formed in a reaction room in which a pressure P of 0.1 Pa ≤ P ≤ 1000 Pa prevails.

20. Method according to at least one of the preceding claims,
**characterized in**
**that** the pressure P in the reaction room is set to 1 Pa ≤ P ≤ 200 Pa.

21. Method according to at least one of the preceding claims,
**characterized in**
**that** the thickness of the hydrogenous SiNₓO_{y} layer is set by coating parameters such as pressure, metal temperature, gas composition, oxygen partial pressure, substrate temperature, distance between metal and substrate, and/or metal geometry.

22. Method according to at least one of the preceding claims,
**characterized in**
**that** the metal forming the dopant or dopants is set to a temperature between 1500° C and 2500° C.

23. Method according to at least one of the preceding claims,
**characterized in**
**that** the gas composition is set such that the ratio between siliceous and nitrogenous reaction gas is 0.001 to 1.0.

24. Method according to at least one of the preceding claims,
**characterized in**
**that** the oxygen partial pressure is set to a value p with 0 < p ≤ 20 Pa.

25. Method according to at least one of the preceding claims,
**characterized in**
**that** the substrate is set to a temperature between 20° C and 600° C.

26. Method according to at least one of the preceding claims,
**characterized in**
**that** the distance between the metal and the substrate is set to between 1 mm and 100 mm.

27. Method according to at least one of the preceding claims,
**characterized in**
**that** the metal used is one having the geometry of a rod, wire and/or a plate.

28. Method according to at least one of the preceding claims,
**characterized in**
**that** the hydrogenous SiNₓO_{y} layer is formed in static coating operation.

29. Method according to at least one of the preceding claims,
**characterized in**
**that** the hydrogenous SiNₓO_{y} layer is formed in a clocked coating operation on the substrate.

30. Method according to at least one of the preceding claims,
**characterized in**
**that** the SiNₓO_{y} layer is formed on the substrate in a continuous throughput coating operation.

31. Method according to at least one of the preceding claims,
**characterized in**
**that** the composition of the process gases without flow rate is set using the reaction speed of the deposition.

32. Method according to at least one of the preceding claims,
**characterized in**
**that** the stoichiometry composition of the SiNₓO_{y} layer is set by changing the parameters gas composition, pressure, metal temperature and/or total gas flow.

33. Method according to at least one of the preceding claims,
**characterized in**
**that** the stoichiometry change in the layer composition of the SiNₓO_{y} layer over its thickness is set by a time change in the parameters gas composition, pressure, metal temperature and/or total gas flow during the static coating operation.

34. Method according to at least one of the preceding claims,
**characterized in**
**that** the stoichiometry change in the layer composition of the SiNₓO_{y} layer over the layer thickness is set by a spatial change of the parameters gas composition, pressure, metal temperature, metal geometry and/or total gas flow along coating distance.

## Revendications

1. Procédé de fabrication d'une cellule solaire par formation d'une couche contenant du silicium hydrogéné sous forme d'une couche anti-réflexion et/ou de passivation sur un substrat en silicium ou en contenant, tel qu'une plaquette ou un film,
**caractérisé en ce**
**que**, lors de la formation de la couche contenant du silicium sous forme de SiN-ₓO_{y} où 0 < x ≤ 1,5 et 0 ≤ y ≤ 2, un ou plusieurs agents de dopage à activité catalytique avec une concentration C de 1 x 10¹⁴ cm⁻³ ≤ C ≤ 1 x 10²¹ cm⁻³ sont ajoutés de manière ciblée dans cette couche, et libèrent de l'hydrogène de la couche de SiNₓO_{y} et/ou incitent la structure de la couche à émettre plus d'hydrogène.

2. Procédé selon la revendication 1,
**caractérisé en ce**
**que** la couche de SiNₓO_{y} est formée avec des valeurs moyennes sur l'épaisseur de la couche de 0,1 < x < 1,5 et 0,01 < y < 2.

3. Procédé selon la revendication 1,
**caractérisé en ce**
**que** le ou les agents de dopage sont emmagasinés avec une concentration C de 1 x 10¹⁶ cm⁻³ ≤ C ≤ 1 x 10¹⁹ cm³.

4. Procédé selon au moins l'une des revendications précédentes,
**caractérisé en ce**
**que** le ou les agents de dopage sont ajoutés avec un gradient sur l'épaisseur de la couche de SiNxOy, sachant en particulier que la concentration C de l'agent de dopage ou des agents de dopage augmente en même temps que l'épaisseur de la couche dans une plage comprise entre 1 x 10¹⁴ cm⁻³ et 1 x 10¹⁹ cm⁻³.

5. Procédé selon au moins l'une des revendications précédentes,
**caractérisé en ce**
**que** le ou les agents de dopage sont répartis de manière homogène dans la couche de SiNₓO_{y}.

6. Procédé selon au moins l'une des revendications précédentes,
**caractérisé en ce**
**que** des atomes de la gamme des métaux réfractaires ou en contenant sont utilisés en tant qu'agent(s) de dopage.

7. Procédé selon au moins l'une des revendications précédentes,
**caractérisé en ce**
**que** du molybdène, du tantale, du tungstène, du platine, du rhénium ou du carbone ou des liaisons de ces derniers sont utilisés en tant qu'agent de dopage.

8. Procédé selon au moins l'une des revendications précédentes,
**caractérisé en ce**
**que** le substrat est appliqué sur une plaque de verre, un carreau de céramique, une tôle d'acier ou un film polymère.

9. Procédé selon au moins l'une des revendications précédentes,
**caractérisé en ce**
**que** le substrat composé de silicium présente une structure cristalline amorphe, microcristalline ou multicristalline.

10. Procédé selon au moins l'une des revendications précédentes,
**caractérisé en ce**
**que** le substrat est composé d'une plaquette de silicium monocristallin ou multi-cristallin ou d'un film de silicium.

11. Procédé selon au moins l'une des revendications précédentes,
**caractérisé en ce**
**qu'**un film fabriqué selon le procédé EFG (Edge-defined Film-fed Growth) est utilisé en tant que film de silicium.

12. Procédé selon au moins l'une des revendications précédentes,
**caractérisé en ce**
**que** du tungstène élémentaire et/ou du WOₓ où 0 ≤ x ≤ 3 est utilisé en tant qu'agent de dopage.

13. Procédé selon au moins l'une des revendications précédentes,
**caractérisé en ce**
**qu'**est utilisé en tant qu'agent de dopage un agent qui, pour former la couche de SiNₓO_{y}, décompose de manière catalytique les gaz utilisés, tels que le silane, le disilane, l'hydrogène, l'ammonium ou l'hydrazine.

14. Procédé selon au moins l'une des revendications précédentes,
**caractérisé en ce**
**que** la couche de SiNₓO_{y} hydrogénée est composée de nitrure de silicium amorphe hydrogénisé.

15. Procédé selon au moins l'une des revendications précédentes,
**caractérisé en ce**
**que** la couche de SiNₓO_{y} est formée de manière homogène.

16. Procédé selon au moins l'une des revendications précédentes,
**caractérisé en ce**
**que** la couche de SiNₓO_{y} varie en épaisseur, sachant qu'avec l'épaisseur de la couche, x augmente dans une plage comprise entre 0,6 et 1,3 et y dans une plage comprise entre 0,1 et 1,0.

17. Procédé selon au moins l'une des revendications précédentes,
**caractérisé en ce**
**que** la couche de SiNₓO_{y} est conçue de telle manière que son épaisseur est comprise entre 30 nm et 150 nm, en particulier entre 50 nm et 110 nm.

18. Procédé selon au moins l'une des revendications précédentes,
**caractérisé en ce**
**que** la couche de SiNₓO_{y} hydrogénée est formée par stimulation de composés azotés ou de silicium gazéiforme et hydrogéné, de préférence du silane, du disilane, de l'hydrogène, de l'ammoniaque et de l'hydrazine sur des métaux réfractaires brûlants.

19. Procédé selon au moins l'une des revendications précédentes,
**caractérisé en ce**
**que** la couche de SiNₓO_{y} est formée dans un espace de réaction dans lequel règne une pression P de 0,1 Pa ≤ P ≤ 1000 Pa.

20. Procédé selon au moins l'une des revendications précédentes,
**caractérisé en ce**
**que** la pression P dans la chambre de réaction est réglée sur 1 Pa ≤ P ≤ 200 Pa.

21. Procédé selon au moins l'une des revendications précédentes,
**caractérisé en ce**
**que** l'épaisseur de la couche de SiNₓO_{y} hydrogénée est déterminée par des paramètres de revêtement tels que la pression, la température du métal, la composition gazeuse, la pression partielle d'oxygène, la température du substrat, la distance entre le métal et le substrat et/ou la géométrie du métal.

22. Procédé selon au moins l'une des revendications précédentes,
**caractérisé en ce**
**que** le métal formant le ou les agents de dopage est réglé à une température entre 1500 °C et 2500 °C.

23. Procédé selon au moins l'une des revendications précédentes,
**caractérisé en ce**
**que** la composition gazeuse est ajustée de telle manière que le rapport entre le gaz de réaction siliceux et le gaz de réaction hydrogéné est compris entre 0,001 et 1,0.

24. Procédé selon au moins l'une des revendications précédentes,
**caractérisé en ce**
**que** la pression partielle d'oxygène est ajustée sur une valeur p de 0 < p ≤ 20 Pa.

25. Procédé selon au moins l'une des revendications précédentes,
**caractérisé en ce**
**que** le substrat est ajusté à une température comprise entre 20 °C et 600 °C.

26. Procédé selon au moins l'une des revendications précédentes,
**caractérisé en ce**
**que** la distance entre le métal et le substrat est comprise entre 1 mm et 100 mm

27. Procédé selon au moins l'une des revendications précédentes,
**caractérisé en ce**
**qu'**est utilisé comme métal un métal présentant la géométrie d'une barre, d'un fil et/ou d'une plaque.

28. Procédé selon au moins l'une des revendications précédentes,
**caractérisé en ce**
**que** la couche de SiNₓO_{y} hydrogénée est formée lors d'une opération de revêtement statique.

29. Procédé selon au moins l'une des revendications précédentes,
**caractérisé en ce**
**que** la couche de SiNₓO_{y} hydrogénée est formée sur le substrat lors d'une opération de revêtement cadencée.

30. Procédé selon au moins l'une des revendications précédentes,
**caractérisé en ce**
**que** la couche de SiNₓO_{y} est formée sur le substrat lors d'une opération de revêtement en continu ininterrompue.

31. Procédé selon au moins l'une des revendications précédentes,
**caractérisé en ce**
**que** la composition du milieu gazeux du procédé est ajustée sans débit à partir de la vitesse de réaction de la précipitation.

32. Procédé selon au moins l'une des revendications précédentes,
**caractérisé en ce**
**que** la composition stoechiométrique de la couche de SiNₓO_{y} est ajustée par modification des paramètres composition gazeuse, pression, température du métal et/ou flux de gaz total.

33. Procédé selon au moins l'une des revendications précédentes,
**caractérisé en ce**
**que** la modification stoechiométrique de la composition de la couche de SiNₓO_{y} est ajustée à partir de son épaisseur par modification dans le temps des paramètres composition gazeuse, pression, température du métal et/ou flux de gaz total pendant le revêtement statique.

34. Procédé selon au moins l'une des revendications précédentes,
**caractérisé en ce**
**que** la modification stoechiométrique de la composition de la couche de SiNₓO_{y} est ajustée à partir de l'épaisseur de la couche par modification dans l'espace des paramètres composition gazeuse, pression, température du métal, géométrie du métal et/ou flux de gaz total sur la distance de revêtement.
